# EUROPÄISCHE PATENTSCHRIFT

(11) **EP 1 273 051 B1**
(45) Veröffentlichungstag und Bekanntmachung des Hinweises auf die Patenterteilung: **19.07.2006**
(21) Anmeldenummer: 01933595.9
(22) Anmeldetag: 06.04.2001
(51) Int. Cl.: H01L 41/09

(54) **PIEZOKERAMISCHER BIEGEWANDLER SOWIE VERWENDUNG DES PIEZOKERAMISCHEN BIEGEWANDLERS**
PIEZOCERAMIC BENDING TRANSDUCER AND USE THEREOF
TRANSDUCTEUR A FLEXION PIEZOCERAMIQUE ET SON UTILISATION

(30) Priorität: 10.04.2000 DE 10017760
(43) Veröffentlichungstag der Anmeldung: 08.01.2003
(73) Patentinhaber: Argillon GmbH, 96257 Redwitz (DE); Festo AG & Co., 73734 Esslingen (DE)
(72) Erfinder: LUBITZ, Karl, 85521 Ottobrunn (DE); RIEDEL, Michael, 96472 Rödental (DE); WEINMANN, Michael, 73655 Plüderhausen (DE); HOFFMANN, Markus, 72649 Wolfschlugen (DE)
(74) Vertreter: Tergau & Pohl Patentanwälte
(86) Internationale Anmeldenummer: PCT/DE2001/001371
(87) Internationale Veröffentlichungsnummer: WO 2001/078160

(56) Entgegenhaltungen:
- WO-A-99/17383
- DE-A- 2 852 795
- US-A- 3 629 625
- PATENT ABSTRACTS OF JAPAN vol. 1998, no. 13, 30. November 1998 (1998-11-30) -& JP 10 225146 A (WAC DATA SERVICE KK), 21. August 1998 (1998-08-21)

## Beschreibung

Die Erfindung betrifft einen piezokeramischen Biegewandler mit einem Tragkörper und mit einem darauf aufgebrachten Stapel aus Schichten aus Piezokeramik und aus zwischen den Schichten angeordneten flächigen Elektroden. Die Erfindung betrifft weiter eine Verwendung eines derartigen Biegewandlers.

Ein derartiger piezokeramischer Biegewandler ist aus der DD 293 918 A5 und der WO 99/17383 bekannt. Gemäß der WO 99/17383 werden zur Ansteuerung des piezokeramischen Biegewandlers die zwischen den Schichten aus Piezokeramik angeordneten Elektroden in Stapelrichtung betrachtet abwechselnd auf positives und negatives Potential gelegt. Dabei sind jeweils benachbarte Schichten aus Piezokeramik in entgegengesetzter Richtung polarisiert, so dass der gesamte Stapel bei Anlegen der Betriebsspannung aufgrund des piezoelektrischen Effektes der Piezokeramik entweder eine Kontraktion oder eine Expansion erfährt.

Weitere Möglichkeiten zur Ansteuerung eines derartigen Stapels aus Schichten aus Piezokeramik sind der DE 34 34 726 C2 zu entnehmen.

Aus der DE 34 34 726 ist weiter als Material für die Piezokeramik der Schichten Bleititanat, Bariumtitanat, Bleizirkontitanat oder Abwandlungen dieser keramischen Substanzen bekannt. Als Material für den Tragkörper ist aus der DD 293 918 A5 Federstahl und aus der WO 97/17383 ein Faserverbundwerkstoff oder Glas bekannt. Der Tragkörper aus einem Faserverbundwerkstoff oder aus Glas führt dabei zu einem guten Wirkungsgrad für die Umwandlung von elektrische in mechanische Energie.

Ein piezoelektrischer Biegewandler mit einem Tragkörper wird in der Regel als ein sogenannter Trimorph aufgebaut. Dies bedeutet, dass der Tragkörper beidseitig jeweils mit mindestens einer piezoelektrisch aktiven Schicht aus Piezokeramik beschichtet ist. Aufgrund des symmetrischen Aufbaus ist die temperaturbedingte Eigenverbiegung eines solchen piezokeramischen Biegewandlers geringer, als wenn der Tragkörper lediglich einseitig beschichtet wäre.

Wird anstelle einer einzigen piezokeramischen Schicht ein Stapel aus vielen piezokeramischen Schichten eingesetzt, so wird die gleiche mechanische Energie bereits bei einer niedrigeren Betriebsspannung zur Verfügung gestellt. Dies ist darin begründet, dass sich aufgrund der geringen Dicke der einzelnen piezokeramischen Schichten in einem Stapel bei gleicher Betriebsspannung gemäß E = U/d, wobei E das elektrische Feld, U die angelegte Spannung und d die Dicke der Keramikschicht angibt, eine größere elektrische Feldstärke ergibt als bei Verwendung einer einzigen Schicht mit der Dicke des Stapels. Der Aufbau der piezoelektrisch aktiven Substanz in Form eines Stapels mit vielen einzelnen Schichten aus Piezokeramik, d.h. in Multilayer-Technik, ist vorteilhaft, wenn kleine Stellwege und große Stellkräfte für den piezokeramischen Biegewandler gefordert werden.

Aus letztgenanntem Grund werden gerade für Anwendungen in einem Ventil piezokeramische Biegewandler in Stapel- oder Multilayer-Bauweise bevorzugt. Nachteiligerweise sind jedoch die Fertigungs- und Materialkosten für einen piezokeramischen Biegewandler in Multilayer-Bauweise relativ hoch. Die piezokeramischen Schichten müssen aufwendig als Folien gezogen werden; es sind viele einzelne Elektrodenschichten erforderlich, was die Materialkosten (AgPd) anhebt. Bei Einsatz eines piezokeramischen Biegewandlers in Multilayer-Bauweise wäre demnach ein Ventil trotz besserer Stelleigenschaften aufgrund des hohen Stückpreises gegenüber einem vergleichbaren Ventil herkömmlicher Bauweise nicht konkurrenzfähig.

Aufgabe der Erfindung ist es daher, einen piezokeramischen Biegewandler in Multilayer-Bauweise anzugeben, der sich günstig herstellen lässt. Weiter ist es Aufgabe der Erfindung, eine Verwendung für einen derartigen piezokeramischen Biegewandler anzugeben.

Die erstgenannte Aufgabe wird für einen piezokeramischen Biegewandler der eingangs genannten Art erfindungsgemäß dadurch gelöst, dass auf der dem Stapel abgewandten Seite des Tragkörpers eine Anpassschicht aus einem Material mit im Wesentlichen gleichen thermischen Ausdehnungskoeffizienten wie die Piezokeramik aufgebracht ist.

Die Erfindung geht dabei von der Überlegung aus, dass bei Anwendung des piezokeramischen Biegewandlers in einem Ventil lediglich zwei definierte Positionen des Biegewandlers notwendig sind. Bei der einen definierten Position des Biegewandlers muss das Ventil geschlossen und bei der anderen definierten Position des Biegewandlers offen sein. Eine weitere, dritte definierte Position des Biegewandlers ist nicht erforderlich. Je nach Ansteuerung des Biegewandlers spricht man von einem normal offenen Ventil, wenn das Ventil bei nicht angesteuertem Biegewandler offen ist, und von einem normal geschlossenen Ventil, wenn das Ventil bei nicht angesteuertem Biegewandler geschlossen ist.

Die Erfindung geht weiter von der Überlegung aus, dass die beiden zur Steuerung eines Ventils erforderlichen Positionen des piezokeramischen Biegewandlers durch seine Ruheposition bei nicht angelegter Spannung und durch eine Auslenkposition bei angelegter Spannung gegeben sind. Es ist demnach lediglich eine Auslenkung des Biegewandlers in eine Richtung erforderlich. Für einen in einem Ventil zum Einsatz kommenden Biegewandler genügt daher eine einseitige Aufbringung des Stapels aus Schichten aus Piezokeramik, im Folgenden Piezostapel genannt, auf den Tragkörper. Ein zweiter, entgegen der Polarisationsrichtung angesteuerter Piezostapel liefert nämlich zur Auslenkung nur einen geringen Beitrag, da die Feldstärke wegen Dipolarisationseffekten begrenzt werden muss. Ohne die Leisungsfähigkeit des Biegewandlers für den Einsatz in Ventilen zu schmälern, kann demnach auf einen Piezostapel verzichtet werden. Dies ist eine kostengünstige Maßnahme, da die Herstellung eines aus vielen einzelnen Piezokeramikschichten mit dazwischenliegenden Elektroden bestehenden Piezostapels teuer ist.

Des Weiteren geht die Erfindung nun von der Überlegung aus, dass ein piezokeramischer Biegewandler mit einem Tragkörper und einem darauf einseitig aufgebrachten Piezostapel gegenüber einem Biegewandler mit einem Tragkörper und beidseitig darauf aufgebrachten Piezostapeln aufgrund des unsymmetrischen Aufbaus eine höhere thermische Eigenverbiegung aufweist, und insofern für eine Verwendung in einem Ventil ungeeignet wäre. Dieses Problem wird dadurch gelöst, dass auf der dem Stapel abgewandten Seite des Tragkörpers eine Anpassschicht aus einem Material mit einem im Wesentlichen gleichen thermischen Ausdehnungskoeffizienten, wie dem der Piezokeramik, aufgebracht ist.

Vorteilhafterweise besteht die Anpassschicht aus einem Glas oder einem Aluminiumoxid. Diese beiden Materialien weisen einen ähnlichen thermischen Ausdehnungskoeffizienten auf wie die üblicherweise als Piezokeramik verwendete Blei-Zirkonat-Titan-Oxidkeramik.

Eine Piezokeramik erhält ihre piezoelektrischen Eigenschaften in der Regel dadurch, dass sie in einem homogenen elektrischen Feld polarisiert wird. Mit der Polarisation ist eine Veränderung des thermischen Ausdehnungskoeffizienten der Piezokeramik verbunden. In einer weiteren vorteilhaften Ausgestaltung der Erfindung besteht daher die Anpassschicht zur Kompensation der thermischen Eigenverbiegung des Biegewandlers aus einer polarisierten Piezokeramik. In diesem Fall ist der thermische Ausdehnungskoeffizient der Anpassschicht identisch mit dem thermischen Ausdehnungskoeffizienten der einzelnen Schichten aus Piezokeramik in dem auf der anderen Seite des Tragkörpers aufgebrachten Stapel. In diesem Fall besteht die Anpassschicht aus einer monolithischen polarisierten Piezokeramik, d.h. aus einer einzigen Schicht aus Piezokeramik.

Als Material für den Tragkörper kann beispielsweise Glas, Metall oder ein Faserverbundwerkstoff verwendet werden. Hinsichtlich einer einfachen Verarbeitbarkeit und einer dauerhaften Verbindung zwischen Piezokeramik und Tragkörper hat es sich jedoch als vorteilhaft erwiesen, wenn der Tragkörper aus einem Faserverbundwerkstoff besteht.

Insbesondere kann eine dauerhafte und feste Verbindung zwischen einer Piezokeramik und dem Tragkörper dann gebildet werden, wenn der Faserverbundwerkstoff ein mit Kohle- oder Glasfasern verstärktes Epoxidharz ist. Zur Herstellung wird als Ausgangsmaterial dann für den Tragkörper ein Epoxidharz-Prepreg (ein noch nicht ausgehärteter Rohling) verwendet, welches durch eine Wärmebehandlung mit der Piezokeramik thermisch verklebt wird.

In einer weiteren vorteilhaften Ausgestaltung der Erfindung erstreckt sich ein freier Teil des Tragkörpers auf einer Befestigungsseite über den Stapel und über die Anpassschicht hinaus. Der freie Teil des Tragkörpers kann in einfacher Art und Weise zur Befestigung des Biegewandlers herangezogen werden. Auch ermöglicht diese Ausgestaltung eine einfache Kontaktierung der einzelnen Elektroden in dem Piezostapel. Beispielsweise kann auf den freien Teil des Tragkörpers ein Kupferplättchen aufgeklebt sein, welches sich teilweise unter den Piezostapel erstreckt und dort mit den jeweiligen Elektroden elektrisch kontaktiert ist. Auf dieses Kupferplättchen kann dann in einfacher Art und Weise ein Anschlussdraht aufgelötet werden.

Vorteilhafterweise sind die Elektroden des Piezostapels zur elektrischen Kontaktierung auf der Befestigungsseite aus der Piezokeramik herausgeführt und an den übrigen Seiten gegenüber der Piezokeramik zurückversetzt. Die als flächige Metallisierung ausgeführten Elektroden treten auf diese Art und Weise lediglich an der Befestigungsseite aus dem Piezostapel oder aus der Anpassschicht heraus. Beim gemeinsamen Versintern des Piezostapels bildet sich durch die zurückversetzte Lage der Elektroden an den Außenseiten eine Sinterhaut, die nach Abschluss des Sinterprozesses die Elektroden dicht gegen die Umwelt abschließt. Eine solche Ausführung der Elektroden innerhalb des Piezostapels ermöglicht daher den Betrieb des piezokeramischen Biegewandlers auch bei hohen Luftfeuchtigkeiten oder in Wasser. Die einzelnen Elektroden sind durch die Sinterhaut sehr gut gegeneinander elektrisch isoliert, was die Kurzschlussfestigkeit des Piezostapels erhöht.

Hinsichtlich der Kurzschlussfestigkeit des piezokeramischen Biegewandlers ist es weiter von Vorteil, wenn der aus dem Piezostapel oder der Vergussmasse herausgeführte Teil der Elektroden mit einer Vergussmasse versiegelt ist. Hierzu wird der Biegewandler in eine Form eingesetzt, welche dann mit der Vergussmasse ausgegossen wird.

Hinsichtlich der leichten Handhabbarkeit ist es von Vorteil, wenn die Vergussmasse ein Epoxidharz ist. Auch können insbesondere mittels Laser aushärtbare Kleber als Vergussmasse verwendet werden. Durch das Vergießen mit einer Vergussmasse ist der gesamte piezokeramische Biegewandler vor Feuchtigkeit geschützt und kann daher selbst in flüssigkeitführenden Ventilen eingesetzt werden.

Hinsichtlich der Verwendung wird die eingangs gestellte Aufgabe erfindungsgemäß dadurch gelöst, dass der piezokeramische Biegewandler, wie in den Patentansprüchen 1 bis 9 beschrieben, als ein Stellelement in einem Ventil, insbesondere in einem Pneumatik-Ventil, eingesetzt wird. Ein solches Ventil ist aufgrund seines guten Preis/Leistungs-Verhältnisses gegenüber einem herkömmlichen Ventil wettbewerbsfähig. Ausführungsbeispiele der Erfindung werden anhand einer Zeichnung näher erläutert. Dabei zeigen:
- FIG 1: einen Längsschnitt durch einen piezokeramischen Biegewandler mit einem Tragkörper, der auf der einen Seite mit einem Stapel aus Schichten aus Piezokeramik und auf der anderen Seite mit einer Anpassschicht in Gestalt einer monolithischen Piezokeramik beschichtet ist,
- FIG 2: einen Querschnitt durch den piezokeramischen Biegewandler gemäß Figur 1 und
- FIG 3: in dreidimensionaler Darstellung die Befestigungsseite des piezokeramischen Biegewandlers gemäß Figur 1.

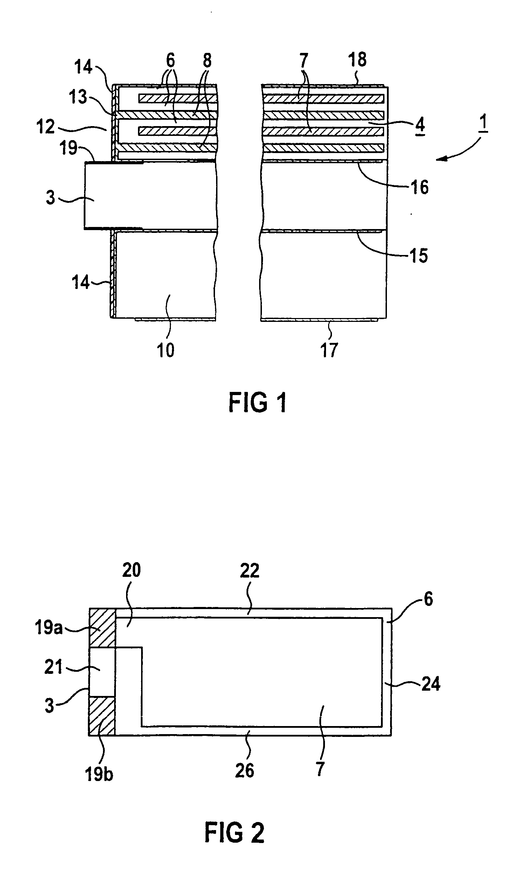

Figur 1 zeigt in einem Längsschnitt einen piezokeramischen Biegewandler 1 mit einem Tragkörper 3 aus einem mit Glasfasern verstärkten Epoxidharz. Auf den Tragkörper 3 ist einseitig ein Stapel 4 aus einer Anzahl von Schichten 6 aus Piezokeramik mit jeweils dazwischen angeordneten Elektroden 7, 8 in Form einer Silber/Palladium-Metallisierungsschicht aufgebracht. Auf der dem Stapel 4 abgewandten Seite des Tragkörpers 3 ist eine Anpassschicht 10 aus einer monolithischen Piezokeramik aufgebracht.

Auf der Befestigungsseite 12 des piezokeramischen Biegewandlers 1 erstreckt sich ein freier Teil des Tragkörpers 3 nach außen. Im Längsschnitt sichtbar sind Teile 13 der Elektroden 8 an der Befestigungsseite 12 aus dem Stapel 4 nach außen geführt und dort miteinander elektrisch kontaktiert. Auch die Elektroden 7 sind - im gezeigten Längsschnitt nicht sichtbar - an anderer Stelle auf die gleiche Art und Weise nach außen geführt und ebenfalls miteinander kontaktiert (siehe Figur 2). Der nach außen geführte Teil 13 der Elektroden 7, 8 ist auf der Befestigungsseite 12 mit einer Vergussmasse 14 aus Epoxidharz versiegelt.

Der Stapel 4 weist weiter eine dem Tragkörper 3 zugewandte Innenelektrode 16 und eine Außenelektrode 18, ebenfalls in Form einer Silber/Palladium-Metallisierung, auf. Die Innen- und Außenelektrode 16 bzw. 18 können auch weggelassen werden. Dies ist z.B. von Vorteil beim Betrieb des Biegewandlers in Feuchte. Auch die Anpassschicht 10 ist mit einer Innenelektrode 15 und einer Außenelektrode 17 versehen. Sowohl die Schichten 6 aus Piezokeramik des Stapels 4 als auch die monolithische Piezokeramik der Anpassschicht 10 werden über die Elektroden 7 und 8 sowie 16 und 18 bzw. 15 und 17 bei Anlegen einer vorgegebenen Spannung polarisiert. Die Anpassschicht 10 weist damit den gleichen thermischen Ausdehnungskoeffizienten auf wie die Schichten 6 aus Piezokeramik. Als Piezokeramik wird eine Blei-Zirkanat-Titan-Oxidkeramik verwendet.

Auf der Befestigungsseite 12 des piezokeramischen Biegewandlers 1 ist auf den Tragkörper 3 ein Kupferplättchen 19 aufgeklebt, welches sich teilweise unter den Stapel 4 erstreckt. Dort ist das Kupferplättchen 19 - wie im Längsschnitt erkennbar, mit den Elektroden 8 elektrisch kontaktiert. Zum Versorgen der Elektroden 8 mit einer Spannung wird ein Anschlusskabel auf das Kupferplättchen 19 gelötet.

In Figur 2 ist ein Querschnitt des piezokeramischen Biegewandlers gemäß Figur 1 dargestellt. Der Querschnitt ist dabei so gewählt, dass eine Elektrode 7 gemäß Figur 1 sichtbar wird. Man erkennt deutlich, dass zur Kontaktierung der Elektroden 7 ein Kupferplättchen 19a und zur Kontaktierung der Elektroden 8 ein Kupferplättchen 19b verwendet ist. Hierzu wird ein Elektrodenteil 20 aus dem Stapel herausgeführt und außen mit dem Kupferplättchen 19a kontaktiert. Die Kupferplättchen 19a und 19b sind auf dem freien Teil 21 des Tragkörpers aufgeklebt.

Weiter wird deutlich, dass die Elektroden - dargestellt sind die Elektroden 7 - an den Seiten 22, 24 und 26 gegenüber den Schichten aus Piezokeramik 6 zurückversetzt sind. Durch dieses Zurückversetzen wird die Kurzschlussfestigkeit des piezokeramischen Biegewandlers bei Feuchtigkeit verbessert.

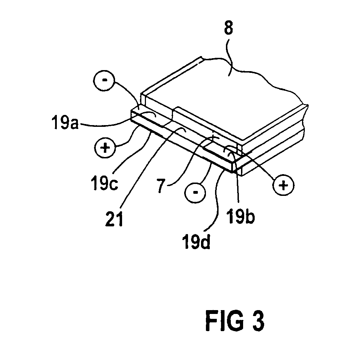

In Figur 3 ist der freie Teil 21 des Tragkörpers 3 in perspektivischer Darstellung gezeigt. Man erkennt deutlich, dass das Kupferplättchen 19a mit allen Elektroden 8 und das Kupferplättchen 19b mit allen Elektroden 7 elektrisch kontaktiert ist. Wird zwischen die Kupferplättchen 19a und 19b eine Spannung angelegt, so zeigt das elektrische Feld in benachbarten Schichten 6 aus Piezokeramik jeweils in entgegengesetzte Richtung. Da die Polarisationsrichtungen benachbarter Schichten 6 aus Piezokeramik ebenfalls in entgegengesetzte Richtung zeigen, führt das Anlegen einer elektrischen Spannung demnach zu einer Kontraktion oder zu einer Expansion sämtlicher Schichten 6 des Stapels 4 und damit zu einer Gesamtkontraktion oder Expansion des Stapels 4. Wird der freie Teil 21 des Tragkörpers 3 festgehalten, so führt das Anlegen einer Spannung an die Kupferplättchen 19a und 19b damit zu einer Auslenkung des anderen Endes des Biegewandlers 1.

Weiter ist in Figur 3 noch ersichtlich, dass die Piezokeramik der Anpassschicht 10 mittels der Kupferplättchen 19c und 19d bei Anlegen einer Spannung ebenfalls polarisiert werden kann.

## Patentansprüche

1. Piezokeramischer Biegewandler (1) mit einem Tragkörper (3) und mit einem darauf aufgebrachten Stapel aus Schichten (6) aus Piezokeramik und aus zwischen den Schichten (6) angeordneten flächigen Elektroden (7, 8),
**dadurch gekennzeichnet, dass** auf der dem Stapel abgewandten Seite des Tragkörpers (3) eine Anpassschicht (10) aus einem Material mit im wesentlichen gleichen thermischen Ausdehnungskoeffizienten wie die Piezokeramik aufgebracht ist.

2. Piezokeramischer Biegewandler (1) nach Anspruch 1,
**dadurch gekennzeichnet, dass** die Anpassschicht (10) aus einem Glas oder einem Aluminiumoxid besteht.

3. Piezokeramischer Biegewandler (1) nach Anspruch 1,
**dadurch gekennzeichnet, dass** die Anpassschicht (10) aus einer polarisierten Piezokeramik besteht.

4. Piezokeramischer Biegewandler (1) nach einem der Ansprüche 1 bis 3,
**dadurch gekennzeichnet, dass** der Tragkörper (3) aus einem Faserverbundwerkstoff besteht.

5. Piezokeramischer Biegewandler (1) nach Anspruch 4,
**dadurch gekennzeichnet, dass** der Faserverbundwerkstoff ein mit Kohle- oder Glasfasern verstärktes Epoxidharz ist.

6. Piezokeramischer Biegewandler (1) nach einem der vorhergehenden Ansprüche,
**dadurch gekennzeichnet, dass** sich ein freier Teil (21) des Tragkörpers (3) auf einer Befestigungsseite (12) über den Stapel und über die Anpassschicht (10) hinaus erstreckt.

7. Piezokeramischer Biegewandler (1) nach Anspruch 6,
**dadurch gekennzeichnet, dass** die Elektroden (7, 8) zur elektrischen Kontaktierung auf der Befestigungsseite (12) aus der Piezokeramik heraus geführt und an den übrigen Seiten (22, 24, 26) gegenüber der Piezokeramik zurückversetzt sind.

8. Piezokeramischer Biegewandler (1) nach Anspruch 7,
**dadurch gekennzeichnet, dass** der heraus geführte Teil (20) der Elektroden (7, 8) auf der Befestigungsseite (12) mit einer Vergussmasse (14) versiegelt ist.

9. Piezokeramischer Biegewandler (1) nach Anspruch 8,
**dadurch gekennzeichnet, dass** die Vergussmasse (14) ein Epoxidharz ist.

10. Verwendung eines piezokeramischen Biegewandlers (1) gemäß einem der vorhergehenden Ansprüche als Stellelement in einem Ventil, insbesondere in einem Pneumatik-Ventil.

## Claims

1. Piezoceramic bending transducer (1) having a support body (3) and having a stack of layers (6) comprising piezoceramic and comprising planar electrodes (7, 8) arranged between the layers (6), which stack is applied to the support body, **characterized in that** a matching layer (10) comprising a material which has substantially the same coefficient of thermal expansion as the piezoceramic bending is applied to that side of the support body (3) which is remote from the stack.

2. Piezoceramic bending transducer (1) according to Claim 1, **characterized in that** the matching layer (10) consists of a glass or an aluminium oxide.

3. Piezoceramic bending transducer (1) according to Claim 1, **characterized in that** the matching layer (10) consists of a polarized piezoceramic.

4. Piezoceramic bending transducer (1) according to one of Claims 1 to 3, **characterized in that** the support body (3) consists of a fibre composite material.

5. Piezoceramic bending transducer (1) according to Claim 4, **characterized in that** the fibre composite material is an epoxy resin reinforced with carbon or glass fibres.

6. Piezoceramic bending transducer (1) according to one of the preceding claims, **characterized in that** a free part (21) of the support body (3), on a securing side (12), extends beyond the stack and beyond the matching layer (10).

7. Piezoceramic bending transducer (1) according to Claim 6, **characterized in that** the electrodes (7, 8) lead out of the piezoceramic on the securing side (12), in order for electrical contact to be made, and are set back with respect to the piezoceramic on the other sides (22, 24, 26).

8. Piezoceramic bending transducer (1) according to Claim 7, **characterized in that** the projecting part (20) of the electrodes (7, 8) is sealed on the securing side (12) with a potting compound (14).

9. Piezoceramic bending transducer (1) according to Claim 8, **characterized in that** the potting compound (14) is an epoxy resin.

10. Use of a piezoceramic bending transducer (1) according to one of the preceding claims as actuator in a valve, in particular in a pneumatic valve.

## Revendications

1. Transducteur à flexion piézocéramique (1) avec un corps porteur (3) et avec une pile constituée de couches (6) en piézocéramique posée dessus et d'électrodes planes (7, 8) disposées entre les couches (6),
**caractérisé en ce qu'**une couche d'adaptation (10) faite d'un matériau présentant sensiblement les mêmes coefficients de dilatation thermique que la piézocéramique est posée du côté du corps porteur (3) opposé à la pile.

2. Transducteur à flexion piézocéramique (1) selon la revendication 1, **caractérisé en ce que** la couche d'adaptation (10) est constituée d'un verre ou d'un oxyde d'aluminium.

3. Transducteur à flexion piézocéramique (1) selon la revendication 1, **caractérisé en ce que** la couche d'adaptation (10) est constituée d'une piézocéramique polarisée.

4. Transducteur à flexion piézocéramique (1) selon l'une quelconque des revendications 1 à 3, **caractérisé en ce que** le corps porteur (3) est constitué d'un matériau composite renforcé par des fibres.

5. Transducteur à flexion piézocéramique (1) selon la revendication 4, **caractérisé en ce que** le matériau composite renforcé par des fibres est une résine époxyde renforcée par des fibres de carbone ou des fibres de verre.

6. Transducteur à flexion piézocéramique (1) selon l'une quelconque des revendications précédentes, **caractérisé en ce qu'**une partie libre (21) du corps porteur (3) s'étend, sur un côté de fixation (12), au-dessus de la pile et au-dessus de la couche d'adaptation (10).

7. Transducteur à flexion piézocéramique (1) selon la revendication 6, **caractérisé en ce que** les électrodes (7, 8) sont sorties hors de la piézocéramique pour la mise en contact électrique sur le côté de fixation (12) et déplacées en arrière par rapport à la piézocéramique sur les autres côtés (22, 24, 26).

8. Transducteur à flexion piézocéramique (1) selon la revendication 7, **caractérisé en ce que** la partie sortie des électrodes (7, 8) sur le côté de fixation (12) est scellée avec une masse de remplissage (14).

9. Transducteur à flexion piézocéramique (1) selon la revendication 8, **caractérisé en ce que** la masse de remplissage (14) est une résine époxyde.

10. Utilisation d'un transducteur à flexion piézocéramique (1) selon l'une quelconque des revendications précédentes comme élément de réglage dans une soupape, en particulier dans une soupape pneumatique.
